# EUROPEAN PATENT APPLICATION

(11) **EP 4 625 490 A2**
(43) Date of publication of application: **01.10.2025**
(21) Application number: 25159788.6
(22) Date of filing: 25.02.2025
(51) Int. Cl.: H01L 23/538, H01L 23/498, H01L 23/00

(54) **METHODS AND APPARATUS TO REDUCE VARIATION IN HEIGHT OF BUMPS AFTER REFLOW**

(30) Priority: 28.03.2024 US 202418620569
(71) Applicant: INTEL Corporation, Santa Clara, CA 95054 (US)
(72) Inventor: CARRAZZONE, Ryan, Chandler, 85226 (US); ARRINGTON, Anastasia, Queen Creek, 85142 (US); CHEN, Haobo, Chandler, 85249 (US); FENG, Hongxia, Chandler, 85249 (US); MAU, Catherine, Phoenix, 85018 (US); MCELHINNY, Kyle, Tempe, 85283 (US); XU, Dingying, Chandler, 85248 (US)
(74) Representative: HGF

(57) **Abstract**

Systems, apparatus, articles of manufacture, and methods to reduce variation in height of bumps after flow are disclosed. An example apparatus includes a substrate of an integrated circuit package, a first bump on the substrate, a second bump on the substrate, and a third bump on the substrate. The first bump includes first solder on a first metal pad. The first metal pad has a first width and a first thickness. The second bump includes second solder on a second metal pad. The second metal pad has a second width and a second thickness. The second width is less than the first width. The second thickness matches the first thickness. The third bump includes third solder on a third metal pad. The third metal pad has a third width. The third width less than the second width.

## Description

### BACKGROUND

In many integrated circuit packages, one or more semiconductor dies are mechanically and electrically coupled to an underlying package substrate. Frequently, the coupling of a die to an underlying substrate is achieved by aligning and connecting metal bumps fabricated on a surface of the die with corresponding pads and/or bumps on a facing surface of the package substrate. As integrated circuits and their associated packages continue to decrease in size, the bumps and/or pads associated with first level interconnects also need to decrease in size.

### BRIEF DESCRIPTION OF THE DRAWINGS

FIG. 1 illustrates an example integrated circuit (IC) package that includes two example semiconductor dies electrically coupled to a package substrate that is electrically coupled to a circuit board.
FIG. 2 illustrates a portion of an example package substrate with an array of bumps before undergoing a reflow process.
FIG. 3 illustrates the example package substrate of FIG. 2 after an example reflow process.
FIG. 4 illustrates the portion of an example package substrate similar to the substrate of FIG. 2 except that different bumps have different initial plated heights.
FIG. 5 illustrates the example package substrate of FIG. 5 after an example reflow process.
FIGS. 6-14 illustrate various stages in the fabrication process of the example package substrate of FIG. 5.
FIGS. 15-17 illustrate various stages in the fabrication process of another example package substrate.
FIG. 18 is a flowchart illustrating an example method of manufacturing the package substrate of FIG. 5 as represented by the different stages of fabrication shown in FIGS. 6-14 and/or the different stages of fabrication shown in FIGS. 15-17.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

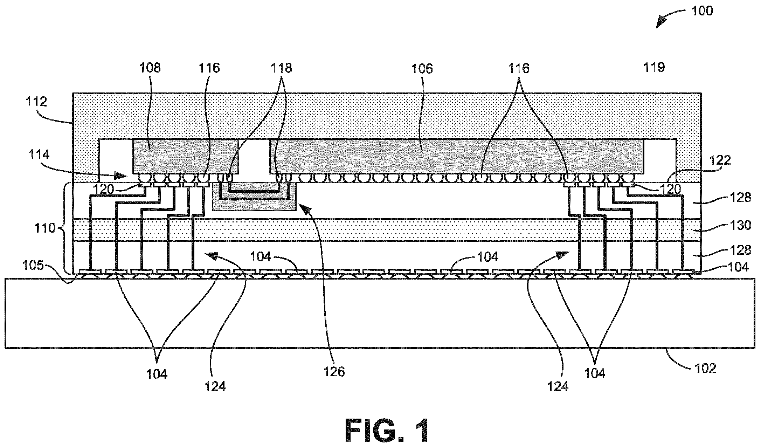

FIG. 1 illustrates an example integrated circuit (IC) package 100 constructed in accordance with teachings disclosed herein. In the illustrated example, the IC package 100 is electrically coupled to a circuit board 102 via an array of contact pads or lands 104 on a mounting surface 105 (e.g., a bottom surface) of the package 100. In some examples, in addition to or instead of the contact pads 104, the IC package 100 may include balls, pins, and/or pads to enable the electrical coupling of the package 100 to the circuit board 102. In this example, the package 100 includes two semiconductor (e.g., silicon) dies 106, 108 (sometimes also referred to as chips or chiplets) that are mounted to a package substrate 110 and enclosed by a package lid or mold compound 112. Thus, the package substrate 110 is an example means for supporting a semiconductor die. While the example IC package 100 of FIG. 1 includes two dies 106, 108, in other examples, the package 100 may have only one die or more than two dies. In some examples, one of the dies 106, 108 (or a separate die) is embedded in the package substrate 110.

The dies 106, 108 can provide any suitable type of functionality (e.g., data processing, memory storage, etc.). More particularly, the example semiconductor dies 106, 108 included in examples disclosed herein can implement controllers, microprocessors, Digital Signal Processors (DSPs), Central Processor Units (CPUs), Graphics Processor Units (GPUs), programmed microprocessors, Field Programmable Gate Arrays (FPGAs), Application Specific Integrated Circuits (ASICs), Reduced Instruction Set Computers (RISCs), any other circuitry and/or combinations thereof. Additionally, example semiconductor dies can be chiplets of a disaggregated die. Each chiplet (also referred to as a tile) may implement a dedicated function. Together, the chiplets may implement complex circuitry. The complex circuitry can be any type of device that can be implemented as a plurality of chiplets that are physically separated from, but communicatively coupled to, one another. For example, programmable circuitry may be implemented by two or more separate chiplets that together implement a microprocessor, etc. Alternatively, in other examples, semiconductor dies may be different chips (e.g., programmable circuitry, a memory, and/or or some other type of component) that together implement a system on a chip (SoC) in a semiconductor package.

As shown in the illustrated example, each of the dies 106, 108 is electrically and mechanically coupled to the package substrate 110 via corresponding arrays of interconnects 114. In the illustrated example of FIG. 1, the interconnects 114 are shown as bumps. However, the interconnects 114 may be any other type of electrical connection in addition to or instead of the bumps shown (e.g., balls, pins, pads, wire bonding, etc.). The electrical connections between the dies 106, 108 and the substrate 110 (e.g., the interconnects 114) are sometimes referred to as first level interconnects. By contrast, the electrical connections between the IC package 100 and the circuit board 102 (e.g., the pads 104) are sometimes referred to as second level interconnects. In some examples, the second level interconnects are used to electrically couple the IC package 100 to some component other than a circuit board (e.g., an interposer, another IC package, etc.). In some examples, one or both of the dies 106, 108 may be stacked on top of one or more other dies and/or an interposer. In such examples, the dies 106, 108 are coupled to the underlying die and/or interposer through a first set of first level interconnects and the underlying die and/or interposer may be connected to the package substrate 110 via a separate set of first level interconnects associated with the underlying die and/or interposer. Thus, as used herein, first level interconnects refer to interconnects (e.g., balls, bumps, pins, pads, wire bonding, etc.) between a die and a package substrate or a die and an underlying die and/or interposer.

As shown in FIG. 1, the interconnects 114 of the first level interconnects include two different types of bumps corresponding to core bumps 116 and bridge bumps 118. As used herein, the core bumps 116 are bumps on the dies 106, 108which electrically connect the dies 106, 108 and components external to the IC package 100. More particularly, as shown in the illustrated example, when the dies 106, 108 are mounted to the package substrate 110, the core bumps 116 are physically connected and electrically coupled to contact pads 120 on an inner surface 122 of the substrate 110. The contact pads 120 on the inner surface 122 of the package substrate 110 are electrically coupled to the pads 104 on the bottom (external) surface 105 of the substrate 110 (e.g., a surface opposite the inner surface 122) via internal interconnects 124 within the package substrate 110. As a result, there is a continuous electrical signal path (e.g., a continuous conductive path) between the interconnects 114 of the dies 106, 108 and the pads 104 mounted to the circuit board 102 that pass through the contact pads 120 and the interconnects 124 provided therebetween.

As used herein, the bridge bumps 118 are bumps on the dies 106, 108through which electrical signals pass between different ones of the dies 106, 108 within the package 100. Thus, as shown in the illustrated example, the bridge bumps 118 of the first die 106 are electrically coupled to the bridge bumps 118 of the second die 108 via an interconnect bridge 126 embedded in the package substrate 110. As represented in FIG. 1, core bumps 116 are typically larger than bridge bumps 118. In some examples, the IC package 100 includes more than one interconnect bridge 126. In some examples, different interconnect bridges can have different sizes of bumps. Thus, while two sizes of bumps are shown in the illustrated example (e.g., the core bumps 116 and the bridge bumps 118), in other examples, there may be more than two sizes of bumps.

In the illustrated example, the internal interconnects 124 are shown in a simplified form. In some examples, the internal interconnects 124 are defined by traces or routing in separate conductive (e.g., metal) layers within build-up regions 128 on one or both sides of a substrate core 130 (e.g., a base substrate) in the package substrate 110. In such examples, the build-up regions 128 include dielectric layers to separate the different conductive layers. In such examples, the traces or routing in the different conductive layers are electrically coupled (to define the complete electrical path of the internal interconnects 124) by conductive (e.g., metal) vias extending between the different conductive layers. Further, in some examples, the internal interconnects 124 include vias that extend through the substrate core 130.

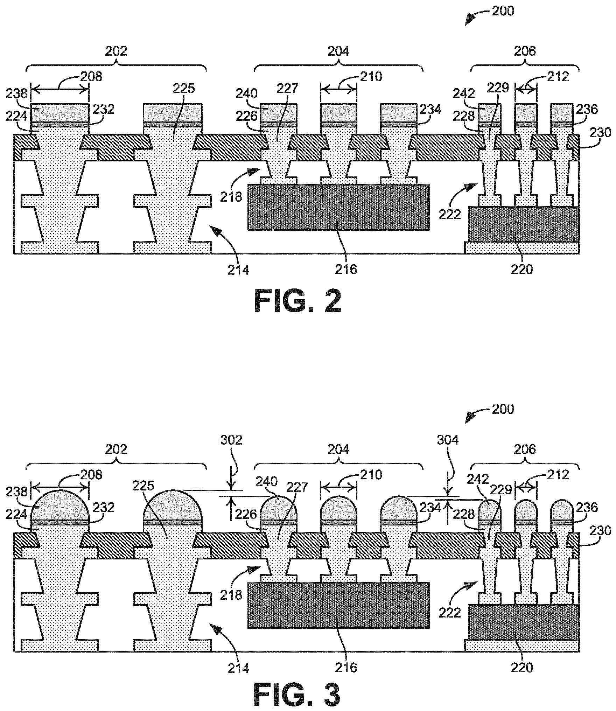

As noted above, in the illustrated example of FIG. 1, the interconnects 114 associated with the first level interconnects include multiple different sizes of bumps including the core bumps 116 and the bridge bumps 118. The fabrication of bumps of different sizes creates challenges detailed in connection with FIGS. 2 and 3. In particular, FIG. 2 illustrates a portion of an example package substrate 200 with an array of bumps before undergoing an example reflow process. FIG. 3 illustrates the example package substrate 200 of FIG. 2 after an example reflow process. In the illustrated example of FIGS. 2 and 3, the example substrate includes a first set of bumps 202 including one or more bumps, a second set bumps 204 including one or more bumps, and a third set of bumps 206. As shown, in this example, the first bumps 202 are larger than the second bumps 204. That is, the first bumps 202 have a first width 208 (e.g., a first diameter, a first critical dimension) that is greater than a second width 210 (e.g., a second diameter, a second critical dimension) of the second bumps 204. Further, as shown, the second bumps 204 are larger than the third bumps 206. That is, the second width 210 of the second bumps 210 is greater than a third width 212 (e.g., a third diameter, a third critical dimension) of the third bumps 206.

In this example, different bumps 202, 204, 206 have different sizes because the bumps have different purposes (e.g., the different bumps 202, 204, 206 are different types of bumps). Specifically, in this example, the first bumps 202 are core bumps (e.g., like the core bumps 116 of FIG. 1)that connect to external components through first conductive interconnects 214 extending through the package substrate 200. The second and third bumps 204, 206 are both bridge bumps (e.g., like the bridge bumps 118 of FIG. 1). However, in this example, the second and third bumps 204, 206 are different sizes because they are electrically coupled to different types of interconnect bridges. Specifically, the second bumps 204 are electrically connected to a first interconnect bridges 216 within the package substrate 200 through second conductive interconnects 218 and the third bumps 206 are electrically connected to a second interconnect bridge 220 within the package substrate 200 through third conductive interconnects 222. The number of each size of bump 202, 204, 206 shown in the figures is for purposes of illustration. In some examples, any suitable number (e.g., 1, 2, 3, etc.) of any of the different bumps 202, 204, 206 may be used.

In the illustrated example of FIG. 2, the first, second, and third bumps 202, 204, 206 are defined by respective first, second, and third bump pads 224, 226, 228 (e.g., metal pads, bump bases) distributed across a solder resist layer 230. In this example, the solder resist layer 230 corresponds to the outermost layer of the substrate onto which a semiconductor die may be attached (e.g., the solder resist layer 230 corresponds to and/or defines the inner surface 122 of FIG. 1). In some examples, the bump pads 224, 226, 228 are made from a conductive (e.g., metal) material that is also used for the internal conductive interconnects 214, 218, 222. More particularly, in some examples, the bump pads 224, 226, 228 are electrically coupled to the internal interconnects 214, 218, 222 through corresponding metal vias 225, 227, 229 provided in solder resist openings within the solder resist layer 230. In some examples, the metal used for the bump pads 224, 226, 228, the internal interconnects 214, 218, 222, and the metal vias 225, 227, 229 include copper. In this example, the bumps 202, 204, 206 include respective barrier layers 232, 234, 236 on the corresponding bump pads 224, 226, 228. The barrier layers 232, 234, 236 provide a barrier separating the bump pads 224, 226, 228 from associated solder layers 238, 240, 242. In some examples, the barrier layers 232, 234, 236 include nickel and the solder layers 238, 240, 242 include a solder material (e.g., tin). In some examples, different materials can be used for the barrier layers 232, 234, 236 and/or for the solder layers 238, 240, 242. In some examples, the barrier layers 232, 234, 236 are omitted.

In some examples, the bump pads 224, 226, 228 for all of the different bumps 202, 204, 206 are fabricated simultaneously during the same plating process. As a result, although the different bump pads 224, 226, 228 have different sizes (e.g., different widths 208, 210, 212), in this example, the different bumps pads 224, 226, 228 have the same (e.g., a matching, a substantially equal) thickness. As used herein, the terms "same," "matching," and "substantially equal" when used in reference to the dimensions of two corresponding features is to indicate the dimensions of the two features are intended to be exactly the same but may have some variability within reasonable tolerances associated with the inherent imperfections of the manufacturing processes involved to produce the corresponding features. More particularly, as used herein, the thickness of the bump pads 224, 226, 228 are the same, matching, and/or substantially equal when the thicknesses vary by less than 2 micrometers. Likewise, in some examples, the barrier layers 232, 234, 236 for all of the different bumps 202, 204, 206 are fabricated simultaneously during the same plating process. As a result, the barrier layers 232, 234, 236 for the different bumps 202, 204, 206 have the same (e.g., a matching, a substantially equal) thickness. More particularly, as used herein, the thickness of the barrier layers 232, 234, 236 are the same, matching, and/or substantially equal when the thicknesses vary by less than 2 micrometers. Although the plating process for all the barrier layers 232, 234, 236 may be performed in a single process, the plating process to provide the bump pads 224, 226, 228 is different than the plating process to provide the barrier layers 232, 234, 236. As such, the thickness of the bump pads 224, 226, 228 is not necessarily the same as the thickness of the barrier layers 232, 234, 236. For instance, in some examples, the bump pads 224, 226, 228 are thicker than the barrier layers 232, 234, 236. Additionally, in this example, the solder layers 238, 240, 242 for all of the different bumps 202, 204, 206 are fabricated simultaneously during the same plating process. As a result, the solder layers 238, 240, 242 for the different bumps 202, 204, 206 have the same (e.g., a matching, a substantially equal) thickness. More particularly, as used herein, the thickness of the solder layers 238, 240, 242 are the same, matching, and/or substantially equal when the thicknesses vary by less than 2 micrometers.

As mentioned above, the illustrated example of FIG. 2 represents the bumps 202, 204, 206 before a reflow process. During the reflow process, the solder in the solder layers 238, 240, 242 is melted into a liquid state and the surface tension of the liquid solder results in the solder changing into a rounded or bulbous shape as shown in the illustrated example of FIG. 3. The solder solidifies in this new shape at the completion of the reflow process to define the final shape of the bumps 202, 204, 206 until connected to a semiconductor die (e.g., during a thermal compression bonding process). Due to the different dimensions (e.g., different widths 208, 210, 212) of the bumps 202, 204, 206, the rounded shape of the different bumps 202, 204, 206 results in differences in the final height (e.g., thickness) of the bumps after reflow. Specifically, larger volumes of solder (which is related to larger bump diameters) result in taller bumps after reflow. Thus, although the initial plated heigh of the bumps 202, 204, 206 is the same as shown in FIG. 2, the final height of the first bumps 202 after reflow is greater than the final height of the second bumps 204 by a first distance 302 as shown in FIG. 3. Further, in this example, the final height of the second bumps 204 after reflow is greater than the final height of the third bumps 206 by a second distance 304.

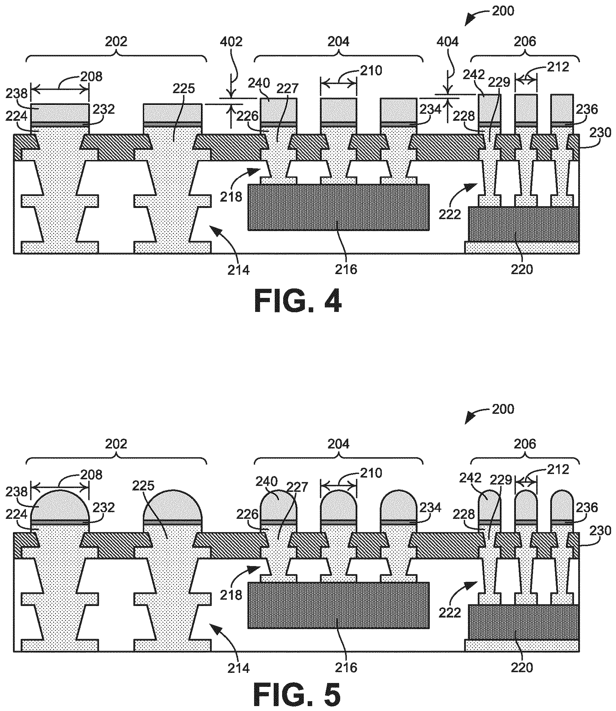

Variation in height across different bumps on a substrate after reflow (as shown in FIG. 3) can create problems for subsequent packaging processes. Specifically, the variation in bump heights can have a deleterious impact on the ability to properly connect the bumps to an interfacing component (e.g., a semiconductor die, an interposer, etc.). The above problem may be mitigated by increasing the height (and, thus, the volume) of solder plated onto smaller bumps relative to the amount (e.g., height, thickness) of solder plated onto larger bumps as shown in the illustrated example of FIG. 4. Specifically, as shown in FIG. 4, the initial plated height of the second bumps 204 before reflow is greater than the initial plated height of the first bumps 202 by a third distance 402 (which may or may not correspond to the first distance 302 shown in FIG. 3). Further, in this example, the initial plated height of the third bumps 206 before reflow is greater than the initial plated height of the second bumps 204 by a fourth distance 404 (which may or may not correspond to the second distance 304 shown in FIG. 3). As a result of the different heights of the bumps prior to reflow (shown in FIG. 4), after reflow the bumps will have a matching height as shown in the illustrated example of FIG. 5. That is, in some examples, the distal end of the bumps 202, 204, 206 after reflow are substantially coplanar (e.g., substantially even). As used herein, "substantially coplanar" bumps and "substantially even" bumps mean the bumps are in a same plane or within 2 micrometers of being in the same plane.

As noted above, bumps with substantially even heights, as shown in FIG. 5, facilitate subsequent packaging processes associated with mounting or attaching semiconductor dies and/or other components to the bumps. However, manufacturing multiple different sized bumps to have the same height after reflow is challenging. This can be done for bumps of two different sizes (e.g., two different widths) using a dual litho (dual lithography) process. In a dual litho process, a first dry film resist is deposited over a solder resist layer (e.g., the solder resist layer 230 of FIGS. 2-5) and then lithographically patterned to produce openings in the first dry film resist that expose the underlying solder resist layer where the bumps are to be fabricated. The sizes of the openings in the first dry film resist can differ to define different critical dimensions (e.g., widths) for different bumps. Once the openings in the first dry film resist are provided, a series of plating processes can be implemented to add material for the bump pads, the barrier layer, and then the solder. These plating processes deposit material into all openings associated with all bumps evenly so that the thickness of the different layers will be substantially the same. Accordingly, in a dual litho process, the solder is plated up to the height needed for the largest bumps (e.g., core bumps). Thereafter, a second dry film resist is deposited over the first dry film resist and lithographically patterned to produce openings in the second dry film resist that expose the openings in the first dry film resist associated with smaller bumps. That is, the largest bumps that have already been plated up to a needed height remain covered by the second dry film resist while the smaller bumps are exposed. As a result, during a second plating process to add additional solder, the solder will only be added to the smaller bumps, thereby increasing the plated height of those bumps without affecting the height of the larger bumps that are covered by the second dry film resist. The second solder plating process adds enough solder to increase the smaller bumps up to a needed height. As discussed above, the needed height for the larger and smaller bumps is defined based on the bump sizes so that, after a reflow process, the height of all the bumps will be consistent (e.g., substantially even). Thus, by implementing the dual litho process, it is possible to achieve two different heights of bumps prior to reflow so that after reflow, the final bump height of all bumps will be substantially even.

While a dual litho process can fabricate bumps with two different bump heights, the dual litho process cannot fabricate bumps with more than two different bump heights (e.g., the three different heights of pre-reflow bumps 202, 204, 206 shown in FIG. 4). As used herein, the term "pre-reflow" refers to a state before undergoing a reflow process. Furthermore, repeating the lithographic loop by depositing and patterning additional layers of dry film resists to plate different (e.g., smaller) bumps to taller heights is not a viable option because of the cost and complexity of the processes involved. Specifically, additional litho loops result in added costs associated with additional time and processing as well as the significant amounts of additional materials required during the additional processes. Furthermore, stacking three or more layers of dry film resist on top of one another through three or more litho loops (which would be needed to plate bumps to three or more different heights) results in a larger plane gap (e.g., the distance from the bumps to be plated from the outer surface of the outermost dry film resist), which increases the risk of voiding and/or poor lamination quality. Moreover, including three or more layers of dry film resists stacked on top of one another can create other problems during subsequent processing operations. For instance, it may not be possible to reliably remove a large stack of resists (e.g., three or more layers of resist) during a stripping process, thereby undermining the integrity of the underlying substrate and/or the bumps fabricated using the stack of resists. More particularly, as the combined thickness of the multiple layers of dry film resist increases, there is a corresponding increase in the risk for damaged bumps due to swelling stress during stripping as well as an increased risk of dry film resist residues not being removed. While the above problems exist for three litho loop processes, thereby rendering such an approach infeasible, these problem are exacerbated for each additional layer of dry film resist (e.g., beyond three) that would be added for each additional height to which different bumps are to be plated.

Examples disclosed herein overcome the above limitations of dual litho processes by controlling the fabrication of different bumps to different heights without the need for multiple layers of dry film resists stacked on top of one another. As a result, examples disclosed herein can plate any number (e.g., 2, 3, 4, 5, 6, 7, etc.) of different sized bumps on a substrate to any suitable height so that the bumps all have a substantially even height after reflow. Specifically, examples disclosed herein use a first dry film resist that is patterned with openings that define the critical dimensions for all bumps to be plated. In some examples, as noted above, there can be any number of different sized openings. As with known dual litho processes, all bumps are initially plated up to the lowest height needed for any of the bumps (e.g., the largest bumps). However, unlike known dual litho processes, rather than applying and patterning another dry film resist to cover the bumps that do not need any more solder while uncovering the rest, examples disclosed herein use selective deposition of an inkjettable resist on the bumps to be covered. Depositing a resist using an inkjet process does not provide the same level of precision (e.g., resolution) possible with a lithographically patterned resist. However, such precision is not needed in disclosed examples because the critical dimensions for all bumps are already defined by the openings in the first (photolithographically patterned) dry film resist. The resist selectively applied through an inkjet process needs only be precise enough to cover the bumps that have already been plated to the needed height while leaving the remaining bumps uncovered for further plating. Furthermore, an inkjet process can selectively cover any suitable portion of the bumps that remain uncovered with the rest of the bumps remaining uncovered in an iterative manner between successive plating processes to produce bumps at many different heights (e.g., three or more). Further still, the selective application of the resist in each iteration can be limited to the areas that are not already covered by the resist so as to avoid producing a large stack of resist layers. As such, there are no significant concerns relating to the strippability (e.g., removal) of the resist materials after all plating processes have been completed. Additionally, examples disclosed herein use significantly less resist material than would be required by iterating through multiple litho loops.

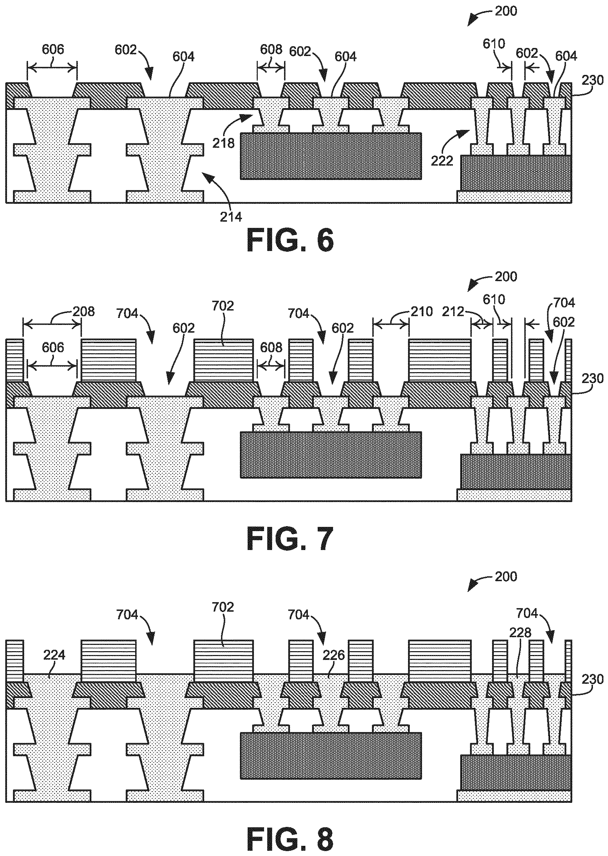

FIGS. 6-14 illustrate various stages in the fabrication process of the example package substrate 200 of FIG. 5 with three different sizes of bumps 202, 204, 206 having final bump heights (after reflow) that are substantially even. Specifically, FIG. 6 shows the package substrate 200 at the stage of fabrication after the solder resist layer 230 has been lithographically patterned to include solder resist openings 602 that expose contact pads 604 associated with the interconnects 214, 218, 222 discussed above in connection with FIG. 2. In this example, the solder resist openings 602 have different sizes. Specifically, in this example, the solder resist openings 602 include three different widths 606, 608, 610 that define the resulting widths of the metal vias 225, 227, 229 associated with the different bumps 202, 204, 206.

FIG. 7 illustrates the stage of fabrication after a dry film resist 702 has been deposited (e.g., via lamination) on the solder resist layer 230 and subsequently patterned to define openings 704 aligned with the openings 602 in the solder resist layer 230. In this example, the diameter or width of openings 704 in the dry film resist 702 corresponds to the widths 208, 210, 212 of the different sized bumps 202, 204, 206 to be fabricated. As shown in the illustrated example, the widths 208, 210, 212 for the openings 704 (and, thus, the bumps 202, 204, 206 to be plated therein) are slightly larger than the corresponding widths 606, 608, 610 of the solder resist openings 704 (and, thus, the metal vias 225, 227, 229 to be plated therein). Further, in some examples, the size of the widths 606, 608, 610 of the solder resist openings 602 differ in a manner corresponding to the differences in the sizes of the widths 208, 210, 212 of the openings 704 in the dry film resist 702. That is, in some examples, the smaller openings 704 in the dry film resist 702 are associated with smaller openings 602 in the solder resist layer 230. In some examples, the difference between the widths 606, 608, 610 of the solder resist openings 602 and the corresponding widths 208, 210, 212 of the dry film resist openings 704 are consistent regardless of the size of the openings. That is, in some examples, the first width 606 in the solder resist layer 230 is less than the first width 208 in the dry film resist 702 by a first amount, and the second width 608 in the solder resist layer 230 is less than the second width 210 in the dry film resist 702 by the a second amount corresponding to (e.g., the same as) the first amount. In other example, the first and second amounts may not be the same for different sizes of bumps but the ratios of the openings in the solder resist layer 230 and the dry film resist 702 for respective ones of the different bumps may be proportionate. That is, in some examples, the first width 606 in the solder resist layer 230 relative to the first width 208 in the dry film resist 702 defines a first ratio, and the second width 608 in the solder resist layer 230 relative to the second width 210 in the dry film resist 702 defines a second ratio corresponding to (e.g., the same as) the first ratio.

FIG. 8 illustrates the stage of fabrication after a first plating process (e.g., copper plating) that deposits metal (e.g., copper) onto the exposed contacts pads 604 to fill the solder resist openings 602 and provide the bump pads 224, 226, 228 at the base of the openings 704 in the dry film resist 702. As shown in the illustrated example, the bumps pads 224, 226, 228 associated with all the bumps 202, 204, 206 are deposited simultaneously during the same plating process. As a result, the bump pads 224, 226, 228 all have the same thickness.

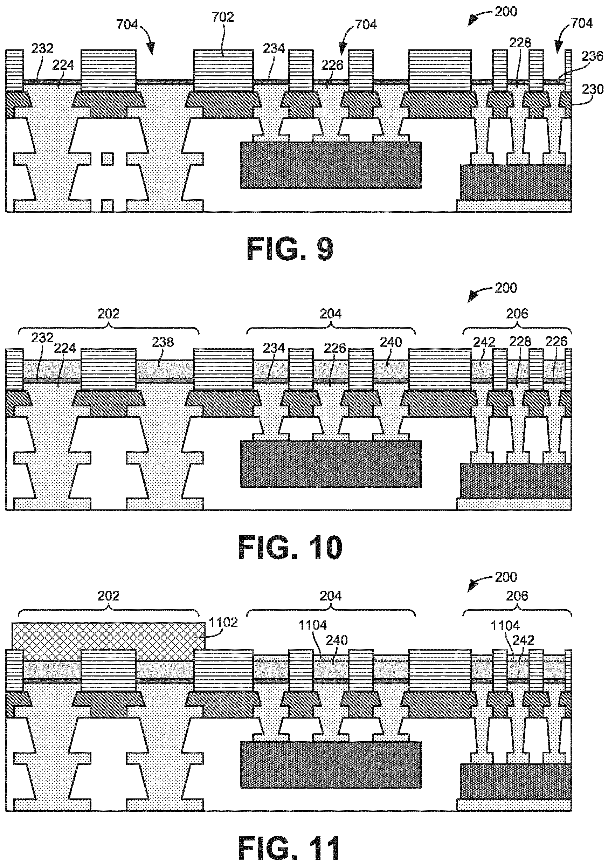

FIG. 9 illustrates the stage of fabrication after a second plating process (e.g., nickel plating) that deposits the barrier layers 232, 234, 236 onto the bump pads 224, 226, 228 in the openings 704 in the dry film resist 702. As shown in the illustrated example, the barrier layers 232, 234, 236 associated with all the bumps 202, 204, 206 are deposited simultaneously during the same plating process. As a result, the barrier layers 232, 234, 236 all have the same thickness.

FIG. 10 illustrates the stage of fabrication after a third plating process (e.g., solder plating) that deposits the solder layers 238, 240, 242 onto the barrier layers 232, 234, 236 in the openings 704 in the dry film resist 702. The addition of solder at this stage defines the basic structure for all of the bumps 202, 204, 206. At the stage of fabrication represented in the illustrated example, the solder layers 238, 240, 242 associated with all the bumps 202, 204, 206 have been deposited simultaneously during the same plating process. As a result, the solder layers 238, 240, 242 all have the same thickness. Accordingly, at this stage in the process, all of the bumps 202, 204, 206 have a matching height. As such, if the processes ended here, during the reflow process, the bumps 202, 204, 206 would end up with uneven heights as shown in FIG. 3. To avoid this outcome, additional solder needs to be added to the smaller bumps 204, 206.

FIG. 11 illustrates the stage of fabrication after a resist material 1102 is selectively deposited over the first bumps 202 (e.g., the largest bumps). In this example, the resist material 1102 is deposited through an inkjet process that specifically targets the first bumps 202 while leaving the remaining bumps 204, 206 uncovered. FIG. 11 also represents the result of a subsequent (fourth) plating process (e.g., a second solder plating process) to add additional solder 1104. In the illustrated example of FIG. 11, the additional solder 1104 increases the height of the solder layers 240, 242 of the second and third bumps 204, 206 above the initial height represented by a dotted line in the illustrated example. In this example, the additional solder 1104 is deposited simultaneously to all the uncovered bumps during the same (fourth) plating process. As a result, the thickness of the solder layers 240, 242 of both the second and third bumps 204, 206 increases by a same amount such that the heights of the second and third bumps 204, 206 remain the same.

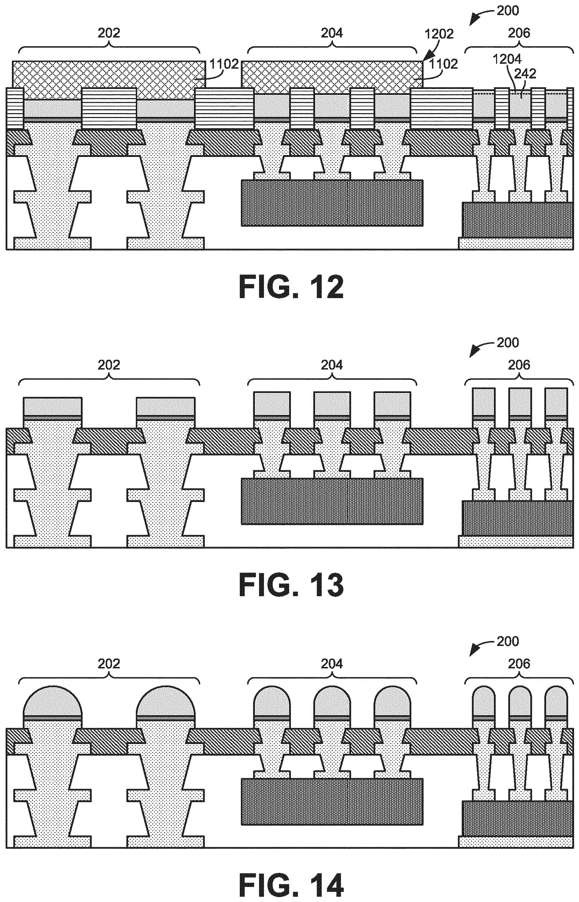

FIG. 12 illustrates the stage of fabrication after additional portion(s) 1202 of the resist material 1102 are selectively deposited over the second bumps 204 (e.g., the intermediate sized bumps). As in FIG. 11, the resist material 1102 is deposited through an inkjet process that specifically targets the second bumps 204 while leaving the third bumps 206 uncovered. In this example, there is no need to deposit the resist material 1102 over the first bumps 202 because they were already covered by the resist material 1102 at the stage of fabrication represented by FIG. 11. FIG. 12 also represents the result of a subsequent (fifth) plating process (e.g., a third solder plating process) to add additional solder 1204. In the illustrated example of FIG. 12, the additional solder 1204 increases the height of the solder layers 242 of the third bumps 206 above the previous height achieved at the stage of fabrication represented in FIG. 11. In this example, the additional solder 1204 is deposited simultaneously to all the uncovered bumps during the same (fifth) plating process. As a result, the thickness of the solder layers 242 of the third bumps 206 increases by a same amount such that the heights of the third bumps 206 remain the same.

FIG. 13 illustrates the stage of fabrication after the resist material 1102 and the dry film resist 702 is removed through a stripping process to produce the package substrate 200 as shown in the illustrated example of FIG. 4. As shown, each of the different sizes of bumps 202, 204, 206 is associated with a different height corresponding to the initial (pre-reflow) height of the respective bumps 202, 204, 206. FIG. 14 illustrates the stage of fabrication after the package substrate 200 undergoes a reflow process to reshape the bumps 202, 204, 206 in line with the example shown in the illustrated example of FIG. 5. As shown, each of the different sizes of bumps 202, 204, 206 following reflow has the same (e.g., matching) bump height.

While the example process of FIGS. 6-14 is described based on an example include bumps of three different sizes, teachings disclosed herein can be applied to any number of bump sizes to produce any number of different heights for the bumps. Further, examples disclosed herein are not limited to applications where bump heights differ merely because the sizes of the bumps differ. Rather, in some examples, bumps with different pre-reflow plated heights can be produced for different bumps that are the same size. Differing the plated (pre-reflow) heights of similarly sized bumps may be suitable in scenarios where the package substrate is such that the deposition of metal during a plating process is not uniform across the substrate. That is, in some examples, metal can plate more rapidly at one location on a substrate relative to another location such that the thickness of the metal being plated at the two locations is not the same. In some instances, an acceptable amount of bump height variation (beyond which bumps would not be considered to be at the same height) depends on the pitch between bumps within a given filed of bumps (e.g., an acceptable height variation for a bump pitch of 45 micrometers is within 13 micrometers, an acceptable height variation for a bump pitch of 36 micrometers is within 8 micrometers, and an acceptable height variation for a bump pitch of 25 micrometers is within 2 micrometers). Further, an acceptable height variation between different bumps fields having different critical dimensions is within 2 micrometers. That is, when two different sized bumps have heights that differ by more than 2 micrometers, the bumps are considered to not be the same height. Additionally or alternatively, in some examples, different bump heights can be created to compensate for anticipated warpage in a package substrate resulting from thermal fluctuations experienced during the fabrication process. In this manner, even though the package substrate is warped, the coplanarity of distal ends of different bumps distributed across the substrate can be maintained. Thus, in some examples, different bump heights may be controlled based on the location of the bumps in addition to or instead of the size of the bumps relative to other bumps.

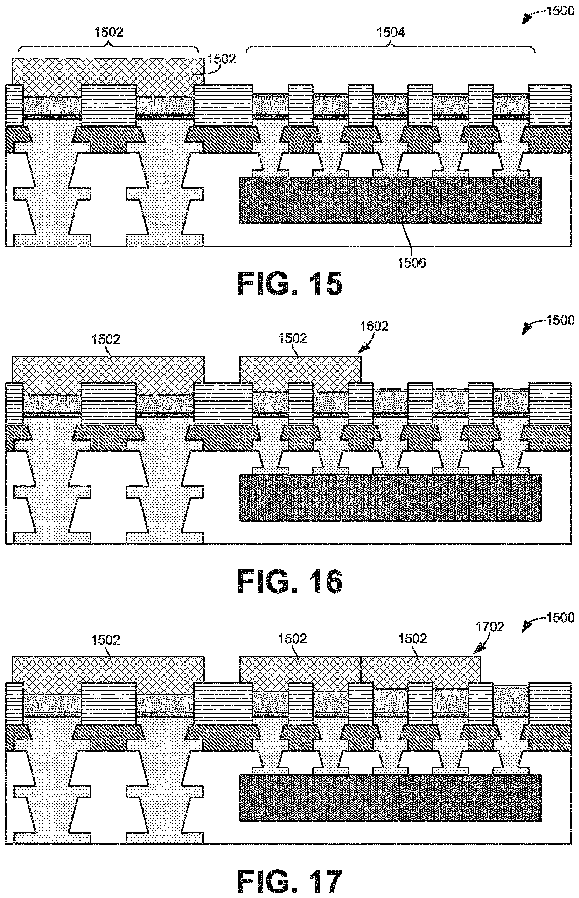

Different stages of fabrication to produce an example package substrate 1500 with different plated heights for bumps having the same size are represented in the illustrated examples of FIGS. 15-17. In particular, the example package substrate 1500 of FIGS. 15-17 includes two sizes of bumps including core bumps 1502 and bridge bumps 1504. In this example, the bridge bumps 1504 are all the same size because they are all connected to the same type of interconnect bridge 1506. FIG. 15 illustrates the stage of fabrication after a resist material 1102 has been selectively deposited over the core bumps 1502 (e.g., the larger bumps) and after a subsequent solder plating process to increase the heights of the bridge bumps 1504. FIG. 16 illustrates the stage of fabrication after additional portion(s) 1602 of the resist material 1102 are selectively deposited over some of the bridge bumps 1504 (e.g., two bumps in this example but any suitable number of bumps could be covered) and the remaining (exposed) bumps under a further plating process to increase the solder thickness. FIG. 17 illustrates the stage of fabrication after additional portion(s) 1702 of the resist material 1102 are selectively deposited over additional ones of the remaining bridge bumps 1504 (e.g., two more bumps in this example but any suitable number of bumps could be covered) and the remaining (exposed) bumps under a further plating process to increase the solder thickness. As shown, this process can be repeated any suitable number of times to provide any suitable number of bumps with different heights to produce bumps with the same size (e.g., same width) but having different plated solder height associated with different quantities of solder.

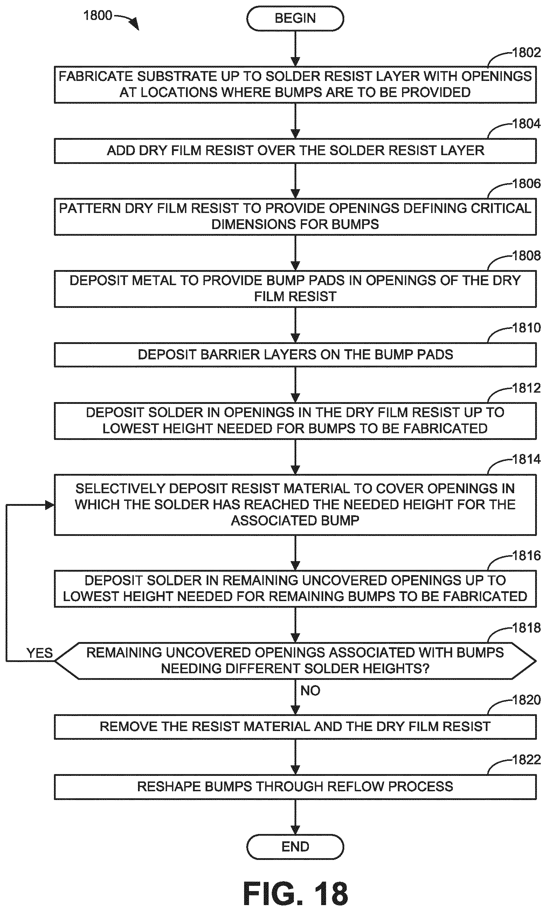

FIG. 18 is a flowchart illustrating an example method of manufacturing the package substrate 200 of FIG. 5 as represented by the different stages of fabrication shown in FIGS. 6-14 and/or the different stages of fabrication shown in FIGS. 15-17. For purposes of explanation, the flowchart of FIG. 18 will be described primarily with reference to the stages of fabrication shown in FIGS. 6-14. In some examples, some or all of the operations outlined in the example method 1800 are performed automatically by fabrication equipment that is programmed to perform the operations. Although the example method of manufacture is described with reference to the flowchart illustrated in FIG. 18, many other methods may alternatively be used. For example, the order of execution of the blocks may be changed, and/or some of the blocks described may be combined, divided, re-arranged, omitted, eliminated, and/or implemented in any other way.

The example process begins at block 1802 by fabricating the package substrate 200 up to the solder resist layer 230 with openings 602 at locations where bumps (e.g., the bumps 202, 204, 206) are to be provided. The completion of block 1802 is represented by the stage of fabrication shown in FIG. 6. At block 1804, the example method includes adding (e.g., via lamination or other suitable deposition process) a dry film resist 702 over the solder resist layer 230. At block 1806, the example method includes patterning the dry film resist 702 to provide openings 704 defining critical dimensions for the bumps. The completion of block 1806 is represented by the stage of fabrication shown in FIG. 7. At block 1808, the example method includes depositing (e.g., via plating) metal to provide bump pads 224, 226, 228 in the openings 704 of the dry film resist 702. The completion of block 1808 is represented by the stage of fabrication shown in FIG. 8. At block 1810, the example method includes depositing (e.g., via plating) barrier layers 232, 234, 236 on the bump pads 224, 226, 228. The completion of block 1810 is represented by the stage of fabrication shown in FIG. 9.

At block 1812, the method includes depositing (e.g., via plating) solder in the exposed openings 704 in the dry film resist 702 up to the lowest height needed for bumps to be fabricated. The completion of block 1812 is represented by the stage of fabrication shown in FIG. 10. At block 1814, the example method includes selectively depositing (e.g., via inkjetting) a resist material 1102to cover the openings 704 in which the solder has reached the needed height for the associated bump. At block 1816, the method includes depositing (e.g., via plating) solder in the remaining uncovered openings 704 up to the lowest height needed for the remaining bumps to be fabricated. The completion of block 1816 is represented by the stage of fabrication shown in FIG. 11.

At block 1818, the example method includes determining whether the remaining uncovered openings are associated with bumps needing different solder heights. If so, the process returns to block 1814 to selectively deposit the resist material 1102 to cover the bumps that are at the needed height and then an additional plating process is performed at block 1816. The completion of the second iteration through this loop is represented by the stage of fabrication shown in FIG. 12. If, at block 1818, it is determined that all remaining uncovered openings are associated with bumps intended to be at the same height, then no additional solder needs to be added. Accordingly, the process advances to block 1820 where the resist material 1102 and the dry film resist 702 are removed. The completion of block 1820 is represented by the stage of fabrication shown in FIG. 13, which corresponds to the stage of fabrication of the package substrate 200 shown in FIG. 4. At block 1822, the example method includes reshaping the bumps through a reflow process. The completion of block 1822 is represented by the stage of fabrication shown in FIG. 14, which corresponds to the stage of fabrication of the package substrate 200 shown in FIG. 5. Thereafter, the example process of FIG. 18 ends and the completed package substrate 200 (as shown in FIGS. 5 and 14) can be further processed by, for example, attaching one or more semiconductor dies (e.g., the dies 106, 108).

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that enable the fabrication of bumps on a substrate having multiple different pre-reflow bump heights. While known techniques use a dual litho process that can provide two different bump heights, examples disclosed herein can provide three or more different bump heights . This is made possible by implementing an inkjet process to selectively deposit a resist over targeted bumps that have been plated to a needed height while leaving other bumps uncovered for further plating.

Further examples and combinations thereof include the following:
Example 1 includes an apparatus comprising a substrate of an integrated circuit package, a first bump on the substrate, the first bump including first solder on a first metal pad, the first metal pad having a first width and a first thickness, a second bump on the substrate, the second bump including second solder on a second metal pad, the second metal pad having a second width and a second thickness, the second width less than the first width, the second thickness matching the first thickness, and a third bump on the substrate, the third bump including third solder on a third metal pad, the third metal pad having a third width, the third width less than the second width.
Example 2 includes the apparatus of example 1, wherein the third metal pad has a third thickness, the third thickness matching the first thickness.
Example 3 includes the apparatus of any one of examples 1 or 2, wherein the first metal pad is coupled to a first metal via in a first opening of the substrate, and the second metal pad is coupled to a second metal via in a second opening of the substrate, the first metal via having a fourth width that is less than the first width, the second metal via having a fifth width that is less than the second width.
Example 4 includes the apparatus of example 3, wherein the fifth width is less than the fourth width.
Example 5 includes the apparatus of any one of examples 3 or 4, wherein the fourth width is less than the first width by a first amount, and the fifth width is less than the second width by a second amount, the first amount corresponding to the second amount.
Example 6 includes the apparatus of any one of examples 3 or 4, wherein the fourth width relative to the first width defines a first ratio, and the fifth width relative to the second width defines a second ratio, the first ratio corresponding to the second ratio.
Example 7 includes the apparatus of any one of examples 1-6, further including a fourth bump to electrically couple the semiconductor die to the substrate, the fourth bump including fourth solder on a fourth metal pad, the fourth metal pad having a same width as one of the first metal pad, the second metal, or the third metal pad, the first, second, or third solder associated with the one of the first metal pad, the second metal, or the third metal pad corresponding to a first quantity of solder, the fourth solder corresponding to a second quantity of solder, the second quantity different than the first quantity.
Example 8 includes the apparatus of any one of examples 1-7, wherein the first bump is a core bump and at least one of the second bump or the third bump is a bridge bump.
Example 9 includes the apparatus of example 8, wherein the second bump is electrically coupled to a first interconnect bridge in the substrate and the third bump is electrically coupled to a second interconnect bridge in the substrate, the second interconnect bridge different from the first interconnect bridge.
Example 10 includes an apparatus comprising a substrate having at least three pads of a same thickness, different ones of the at least three pads have different widths, the different widths including at least three different widths, solder on the at least three pads, and a semiconductor die electrically coupled to at least one of the at least three pads via the solder.
Example 11 includes the apparatus of example 10, wherein a first pad of the at least three pads corresponds to a core bump, a second pad of the at least three pads corresponds to a first bridge bump, and a third pad of the at least three pads corresponds to a second bridge bump, the first bridge bump electrically coupled to a first interconnect bridge in the substrate, the second bridge bump electrically coupled to a second interconnect bridge in the substrate, the second interconnect bridge different from the first interconnect bridge.
Example 12 includes the apparatus of any one of examples 10 or 11, wherein the at least three pads include at least two pads having a same width, a first quantity of solder on a first one of the at least two pads different from a second quantity of solder on a second one of the at least two pads.
Example 13 includes a method comprising depositing, via a first plating process, a first layer of solder onto a substrate, a first portion of the first layer of solder on a first pad associated with a first bump, a second portion of the first layer of solder on a second pad associated with the second bump, depositing, via an inkjet process, a resist material onto the first portion of the first layer of solder, and depositing, via a second plating process, a second layer of solder onto the substrate, a first portion of the second layer of solder on the second portion of the first layer of solder.
Example 14 includes the method of example 13, wherein the depositing of the resist material avoids depositing the resist material onto the second portion of the first layer of solder.
Example 15 includes the method of any one of examples 13 or 14, further including patterning a resist to include a first opening and a second opening, the first and second openings to expose an underlying layer through the resist, and depositing metal in the first and second openings, the metal in the first opening providing the first pad, the metal in the second opening providing the second pad.
Example 16 includes the method of example 15, wherein the first opening is larger than the second opening.
Example 17 includes the method of example 15, wherein the first opening has a same size as the second opening.
Example 18 includes the method of any one of examples 15-17, wherein the underlying layer is a solder resist layer including first and second solder resist openings, the first opening in the resist to align with the first solder resist opening, the second opening in the resist to align with the second solder resist opening, a size of the first and second openings in the resist corresponding to a size of the first and second solder resist openings.
Example 19 includes the method of any one of examples 15-17, wherein the resist is to include a third opening, and the metal is to be deposited into the third opening to provide a third pad for a third bump.
Example 20 includes the method of example 19, wherein the inkjet process is a first inkjet process, the first plating process includes depositing a third portion of the first layer of solder onto the third pad, and the second plating process includes depositing a second portion of the second layer of solder onto the third portion of the first layer of solder, the method including depositing, via a second inkjet process, the resist material onto the first portion of the second layer of solder, and depositing, via a third plating process, a third layer of solder onto the substrate, a first portion of the third layer of solder on the second portion of the second layer of solder.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus comprising:
a substrate of an integrated circuit package;
a first bump on the substrate, the first bump including first solder on a first metal pad, the first metal pad having a first width and a first thickness;
a second bump on the substrate, the second bump including second solder on a second metal pad, the second metal pad having a second width and a second thickness, the second width less than the first width, the second thickness matching the first thickness; and
a third bump on the substrate, the third bump including third solder on a third metal pad, the third metal pad having a third width, the third width less than the second width.

2. The apparatus of claim 1, wherein the third metal pad has a third thickness, the third thickness matching the first thickness.

3. The apparatus of any one of claims 1 or 2, wherein the first metal pad is coupled to a first metal via in a first opening of the substrate, and the second metal pad is coupled to a second metal via in a second opening of the substrate, the first metal via having a fourth width that is less than the first width, the second metal via having a fifth width that is less than the second width.

4. The apparatus of claim 3, wherein at least one of the fifth width is less than the fourth width or the fourth width is less than the first width by a first amount, and the fifth width is less than the second width by a second amount, the first amount corresponding to the second amount.

5. The apparatus of any one of claims 3 or 4, wherein the fourth width relative to the first width defines a first ratio, and the fifth width relative to the second width defines a second ratio, the first ratio corresponding to the second ratio.

6. The apparatus of any one of claims 1-5, further including a fourth bump to electrically couple the semiconductor die to the substrate, the fourth bump including fourth solder on a fourth metal pad, the fourth metal pad having a same width as one of the first metal pad, the second metal, or the third metal pad, the first, second, or third solder associated with the one of the first metal pad, the second metal, or the third metal pad corresponding to a first quantity of solder, the fourth solder corresponding to a second quantity of solder, the second quantity different than the first quantity.

7. The apparatus of any one of claims 1-6, wherein the first bump is a core bump and at least one of the second bump or the third bump is a bridge bump.

8. The apparatus of claim 7, wherein the second bump is electrically coupled to a first interconnect bridge in the substrate and the third bump is electrically coupled to a second interconnect bridge in the substrate, the second interconnect bridge different from the first interconnect bridge.

9. A method comprising:
depositing, via a first plating process, a first layer of solder onto a substrate, a first portion of the first layer of solder on a first pad associated with a first bump, a second portion of the first layer of solder on a second pad associated with the second bump;
depositing, via an inkjet process, a resist material onto the first portion of the first layer of solder; and
depositing, via a second plating process, a second layer of solder onto the substrate, a first portion of the second layer of solder on the second portion of the first layer of solder.

10. The method of claim 9, wherein the depositing of the resist material avoids depositing the resist material onto the second portion of the first layer of solder.

11. The method of any one of claims 9 or 10, further including:
patterning a resist to include a first opening and a second opening, the first and second openings to expose an underlying layer through the resist; and
depositing metal in the first and second openings, the metal in the first opening providing the first pad, the metal in the second opening providing the second pad.

12. The method of claim 11, wherein the first opening is larger than the second opening or has a same size as the second opening.

13. The method of any one of claims 11 or 12, wherein the underlying layer is a solder resist layer including first and second solder resist openings, the first opening in the resist to align with the first solder resist opening, the second opening in the resist to align with the second solder resist opening, a size of the first and second openings in the resist corresponding to a size of the first and second solder resist openings.

14. The method of any one of claims 11-13, wherein the resist is to include a third opening, and the metal is to be deposited into the third opening to provide a third pad for a third bump.

15. The method of claim 14, wherein the inkjet process is a first inkjet process, the first plating process includes depositing a third portion of the first layer of solder onto the third pad, and the second plating process includes depositing a second portion of the second layer of solder onto the third portion of the first layer of solder, the method including:
depositing, via a second inkjet process, the resist material onto the first portion of the second layer of solder; and
depositing, via a third plating process, a third layer of solder onto the substrate, a first portion of the third layer of solder on the second portion of the second layer of solder.
